# FASCICULE DE BREVET EUROPEEN

(11) **EP 0 971 313 B1**
(45) Date de publication et mention de la délivrance du brevet: **15.10.2008**
(21) Numéro de dépôt: 99401517.0
(22) Date de dépôt: 18.06.1999
(51) Int. Cl.: G06K 19/077

(54) **Procédé de fabrication d'une carte à microcircuit permettant de limiter les contraintes mécaniques transmises à celui-ci**
Herstellungsverfahren für eine Chipkarte zur Begrenzung mechanischer Spannungen auf ihr
Chip card manufacturing procedure limiting the mechanical stresses on it

(30) Priorité: 07.07.1998 FR 9808673
(43) Date de publication de la demande: 12.01.2000
(73) Titulaire: OBERTHUR TECHNOLOGIES, 75017 Paris (FR)
(72) Inventeur: Venambre, Jacques, 14123 Ifs (FR); Bouchez, François, 14790 Verson (FR)
(74) Mandataire: Santarelli

(56) Documents cités:
- EP-A- 0 371 855
- EP-A- 0 599 194
- EP-A- 0 688 051
- DE-C- 4 431 754

## Description

L'invention se rapporte à un procédé de fabrication d'une carte à microcircuit du type consistant notamment à aménager une cavité dans une partie de l'épaisseur de la carte en matériau isolant formant le support et à fixer le microcircuit dans une telle cavité en le reliant à un réseau de conducteurs permettant d'établir des liaisons électriques entre la cavité et une face de la carte.

L'invention concerne plus particulièrement un procédé particulier de montage du microcircuit et du réseau de conducteurs, permettant de réduire de façon très importante les contraintes susceptibles d'être transmises au microcircuit lorsque la carte subit des déformations, après sa fabrication.

L'invention concerne également une carte à microcircuit réalisée par mise en oeuvre d'un tel procédé.

Dans le domaine de la fabrication des cartes à microcircuit, il est connu de monter le microcircuit dans une cavité ménagée dans une partie de l'épaisseur de la carte en matière plastique formant le support. La cavité est ouverte sur une face de cette carte. Sur cette face, au fond de celle-ci et sur ses côtés, il est classique d'agencer un réseau de conducteurs permettant de raccorder électriquement des zones de connexion du microcircuit à des plages de raccordement extérieur définies sur ladite face tout autour de la cavité. Lorsqu'on utilise un tel réseau de conducteurs, il est avantageux d'utiliser une technique de montage particulière du microcircuit, connue sous le nom de "flip chip". En effet, le microcircuit comporte des zones de connexion qui sont toutes définies sur une face de celui-ci et qui permettent d'avoir accès au microprocesseur et à des mémoires associées. Cette technique de montage consiste à fixer et connecter électriquement, en une même opération, le microcircuit audit réseau de conducteurs et plus particulièrement à des parties de celui-ci qui s'étendent et adhèrent sur le fond de la cavité.

Le document EP 0 599 194 A décrit un tel procédé.

Du fait que le microcircuit est rigidement fixé au fond de la cavité, toute déformation de la carte se traduit par des contraintes qui sont transmises au microcircuit et risquent de l'endommager ou le rendre inutilisable, notamment en cas de fissuration du matériau (silicium) constituant le microcircuit ou en cas de rupture d'une interconnexion électrique.

L'invention permet de surmonter ces difficultés et d'améliorer la fiabilité d'une telle carte à microcircuit.

L'idée de base de l'invention consiste à réaliser à part un module constitué à partir d'une feuille de matériau électriquement conducteur, destiné à former ledit réseau de conducteurs et à y adapter le microcircuit de façon que celui-ci soit fixé et connecté aux conducteurs dudit réseau avant que l'ensemble ne soit assemblé à la carte par fixation des plages de raccordement extérieur dudit réseau sur la face de la carte, tout autour de l'ouverture de la cavité. Autrement dit, à la différence des techniques d'assemblage connues impliquant la fixation du microcircuit au fond de la cavité de la carte, ledit microcircuit se trouve séparé du fond de la cavité (voire "suspendu" dans celle-ci) et le réseau de conducteurs assure une liaison souple entre le microcircuit et la carte, ce qui réduit fortement la communication des contraintes de déformation appliquée à la carte.

Plus précisément, l'invention concerne un procédé de fabrication d'une carte à microcircuit consistant notamment à aménager une cavité dans une partie de l'épaisseur d'une carte en matériau isolant formant support, ladite cavité ouvrant sur une face de cette carte, à créer un réseau de conducteurs pour établir des liaisons électriques entre la cavité et ladite face de la carte et à connecter ledit microcircuit à ce réseau de conducteurs, caractérisé en ce qu'il consiste à réaliser à part un module comprenant ledit réseau et ledit microcircuit de façon telle qu'une ébauche dudit réseau soit conformée pour définir au moins en partie un réceptacle et que ledit microcircuit soit fixé à ce réseau en maintenant des parties différentes dudit réseau en position les unes par rapport aux autres, puis, successivement ou non, à découper des parties extérieures de ladite ébauche matérialisant des plages de raccordement extérieur, à placer ledit module dans ladite cavité avec lesdites plages de raccordement extérieur reposant sur ladite face et à fixer ces plages de raccordement extérieur sur ladite face.

En d'autres termes, selon un premier mode de réalisation possible, le microcircuit n'est pratiquement relié à la carte que par l'intermédiaire d'un nombre limité de jonctions souples constituées par des pistes du réseau de conducteurs lui-même, ces pistes aboutissant aux plages de raccordement extérieur collées contre la face de la carte, tout autour de la cavité. Ce type de montage réduit considérablement les contraintes transmises au microcircuit. Cependant, le reste de la cavité peut être rempli de différents types de résines ou matériaux de remplissage analogues, plus ou moins souples et déformables.

L'invention concerne également une carte à microcircuit réalisée par mise en oeuvre du procédé défini ci-dessus.

L'invention sera mieux comprise et ressortira plus clairement de plusieurs variantes du procédé conforme à son principe, données uniquement à titre d'exemple et faites en référence aux dessins annexés dans lesquels:
- les figures 1 à 9 et la figure 2b illustrent le déroulement d'un procédé conforme à l'invention ; et
- les figures 10 à 18 et les figures 11b, 12b et 14b illustrent le déroulement d'une variante du procédé.

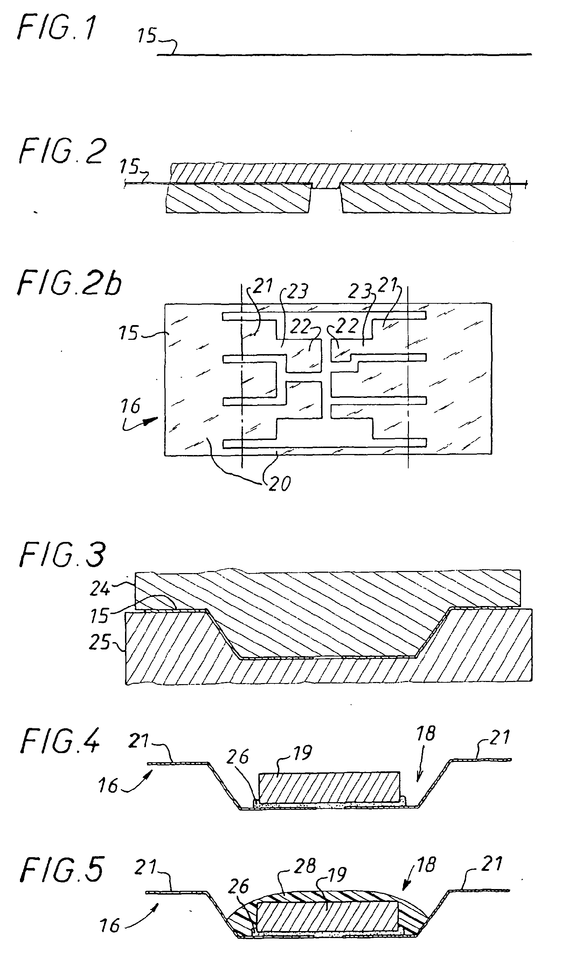

En considérant plus particulièrement les figures 1 à 8, on va décrire un premier procédé possible pour fabriquer une carte à microcircuit.

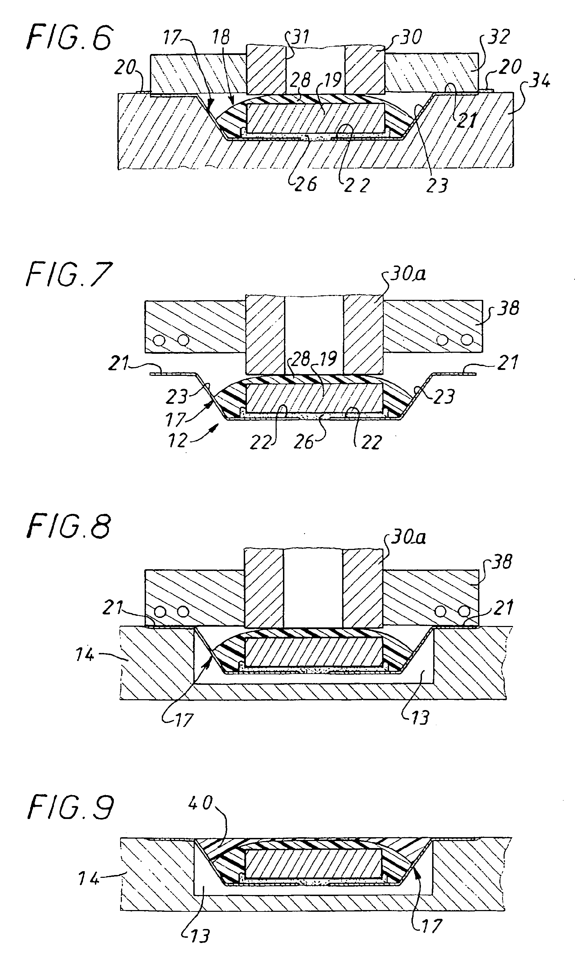

Sur les dessins, les figures 1 à 7 illustrent plus particulièrement l'élaboration d'un module 12 et les figures 8 et 9 montrent le montage de ce module dans la cavité 13 de la carte 14.

La fabrication du module 12 commence à partir d'une feuille de matériau conducteur 15 et de préférence une bande (figure 1). Cette feuille peut être en cuivre éventuellement et de préférence nickelée et dorée. Classiquement, la bande présente une épaisseur très faible de l'ordre de quelques dizaines de microns. Elle est destinée à former le réseau de conducteurs mentionné ci-dessus. Une première étape possible consiste à définir une ébauche 16 du réseau 17 sur la bande de matériau conducteur, cette ébauche étant appelée à définir, au moins partiellement, un réceptacle 18 apte à contenir le microcircuit 19 électriquement connecté à des éléments de l'ébauche. Pour ce faire, selon l'exemple, la bande est gravée, découpée ou usinée (éventuellement par mise en oeuvre d'un faisceau laser), de façon à isoler les uns des autres tous les éléments du réseau mais en incluant une marge extérieure 20 les réunissant. Cette étape symbolisée à la figure 2 aboutit par exemple à créer une configuration représentée sur la figure 2b. On y retrouve donc déjà, en grande partie délimitées, les plages de raccordement extérieur 21, les plages de connexion 22 destinées à être fixées aux zones de connexion du microcircuit et les pistes 23 qui les réunissent.

Ensuite, la bande de cuivre est conformée à l'aide d'un système poinçon-matrice 24, 25 comme représenté à la figure 3. Cette conformation aboutit à placer les plages de raccordement extérieur 21 à un niveau différent des plages de connexion 22. Bien entendu, la différence de niveau introduite par cette étape de conformation doit être inférieure à la profondeur de la cavité qui sera réalisée séparément dans la carte ; elle doit aussi être supérieure à l'épaisseur du microcircuit 19.

Ensuite, on dépose sur la zone destinée à recevoir le microcircuit, c'est-à-dire plus particulièrement sur les plages de connexion 22 de l'ébauche 16, une couche d'adhésif 26 pour la fixation du microcircuit 19. Cette colle peut être une colle isolante si le microcircuit comporte des surépaisseurs sur ses zones de connexion. Dans ce cas, la couche de colle est d'épaisseur suffisante pour assurer l'adhésion du microcircuit tout en permettant un contact électrique direct entre les surépaisseurs et les plages de connexion. En revanche, si le microcircuit ne comporte pas de surépaisseurs sur ses zones de connexion, il peut être collé au moyen d'une colle anisotrope ; il suffit que ses propres zones de connexion soient en regard des plages de connexion 22. On rappelle qu'une colle anisotrope est une colle électriquement conductrice suivant une direction où elle se trouve en faible épaisseur et qu'elle est en revanche électriquement isolante dans les autres directions.

L'opération suivante (figure 4) consiste à fixer le microcircuit 19 par la technique connue dite : "flip-chip" en le déposant dans le réceptacle 18 de façon que ses zones de connexion regroupées sur l'une de ses faces soient respectivement électriquement connectées aux plages de connexion 22 de ladite ébauche. On peut utiliser l'une ou l'autre des deux colles mentionnées ci-dessus en fonction de la structure du microcircuit. D'autres modes de fixation peuvent aussi être utilisés, notamment la soudure.

Ensuite (figure 5), le microcircuit 19 est recouvert d'une goutte de résine 28, cette dernière devenant rigide après polymérisation. La polymérisation peut être obtenue thermiquement et/ou par insolation aux rayons ultraviolets. En variante, on peut remplacer la pose de la goutte de résine par une phase de surmoulage non représentée.

A partir de ce moment, il est important de noter que le microcircuit 19 ainsi fixé audit réseau de conducteurs, maintient définitivement les positions relatives des différentes parties de ce réseau. Autrement dit, à partir de ce moment, les marges 20 visibles sur la figure 2b ne sont plus nécessaires. On peut donc les éliminer.

C'est l'opération représentée sur la figure 6. L'ébauche du module est prise en charge par un organe de préhension 30 comportant un orifice central 31 relié à une source d'aspiration. Cet organe de préhension est associé à un outil de découpage 32 mobile axialement par rapport à l'organe de préhension. L'ébauche est placée dans une matrice de découpage 34 et l'outil 32 est actionné pour éliminer les marges, ce qui a pour effet d'achever la constitution du réseau 17 en individualisant les plages de raccordement extérieur. Le module 12 est alors achevé. Après quoi, ce module est repris (figure 7) par un autre organe de préhension 30a analogue, fonctionnant par aspiration mais combiné à un outil de fixation chauffant 38, mobile axialement par rapport à l'organe de préhension 30a. Par ce moyen, le module 12 est placé dans la cavité 13, préparée à cet effet, de la carte en matière plastique. C'est la situation illustrée à la figure 8. L'outil chauffant 38 est actionné pour fixer les plages de raccordement extérieur sur la face de la carte. L'outil 38 vient plaquer à chaud lesdites plages de raccordement extérieur sur cette surface et le module est par ce moyen fixé à la carte, le microcircuit 19 prenant place dans la cavité 13 et étant essentiellement maintenu dans celle-ci, au moins à ce stade du procédé, par le réseau de conducteurs 17.

L'adhérence des plages de raccordement extérieur 21 sur la surface de la carte se fait par collage si le ruban de matériau conducteur a été auparavant enduit d'une couche de colle activable à chaud. Il peut aussi se faire par pénétration de la matière thermoplastique constituant la carte 14 dans des micropores ménagés à la surface du ruban conducteur. De tels pores peuvent être créés par traitement mécanique, chimique ou thermique.

La phase finale consiste à remplir la cavité 13 avec une résine 40 polymérisant thermiquement ou par insolation aux rayons ultraviolets. Plusieurs cas sont possibles. On peut utiliser une résine dure (c'est-à-dire à faible coefficient d'élongation après polymérisation) et à viscosité assez élevée avant polymérisation. Dans ce cas, elle ne coule pas à travers les interstices séparant les différentes parties du réseau 17 de conducteurs. Dans ce contexte, le microcircuit est placé dans un milieu très rigide du côté extérieur de la carte et dans le vide du côté intérieur, c'est-à-dire qu'il ne touche pas directement le fond de la cavité 13. Cette configuration est favorable pour réduire considérablement les contraintes transmises au microcircuit lorsque la carte est déformée. Inversement, on peut aussi effectuer le remplissage par une résine relativement fluide susceptible de pouvoir remplir entièrement la cavité de la carte. Dans ce cas, la résine est de préférence assez molle après durcissement pour limiter la transmission des contraintes au microcircuit. On peut aussi commencer le remplissage par une résine fluide et molle et le terminer par une résine visqueuse et rigide. On peut aussi fixer le module dans la carte par l'intermédiaire d'un adhésif souple placé au fond de la cavité 13.

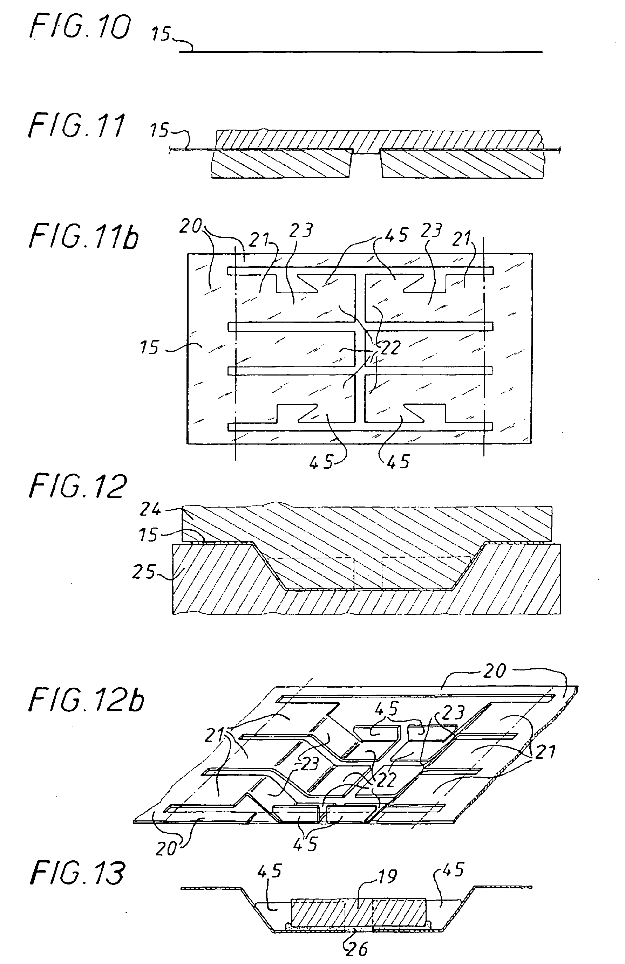

Les figures 10 à 17 illustrent une variante possible du procédé.

La fabrication du module commence (figure 10), comme précédemment, à partir d'une feuille de matériau conducteur 15, de préférence une bande. Cette feuille est ensuite découpée (figure 11) mais, selon une configuration différente, illustrée à la figure 11b, qui laisse subsister, sur les côtés perpendiculaires aux plages de raccordement 21 et dans le prolongement de certaines plages de connexion 22, des rabats 45 destinés à être pliés au cours de la phase de conformation. Comme dans l'exemple précédent, la bande peut être gravée, découpée ou usinée de façon à isoler les uns des autres (figure 11) tous les éléments du réseau 17 en incluant cependant une marge extérieure 20 les réunissant.

Ensuite, la feuille 15 est conformée à l'aide d'un système poinçon-matrice comme représenté à la figure 12. Le résultat de cette conformation est représenté à la figure 12b. Ladite conformation aboutit à placer les plages de raccordement extérieur 21 à un niveau différent des plages de connexion 22. La différence de niveau introduite doit être inférieure à la profondeur de la cavité et supérieure à l'épaisseur du microcircuit. Cependant, en raison de la définition des rabats 45 à l'étape précédente, ladite étape de conformation permet de créer un réceptacle 18a sensiblement fermé sur cinq faces, avant le montage du microcircuit 19. Ce réceptacle apparaît plus précisément sur la figure 12b.

Ensuite, on dépose sur la zone destinée à recevoir le microcircuit, c'est-à-dire plus particulièrement sur les plages de connexion de l'ébauche, une couche d'adhésif 26 pour la fixation du microcircuit 19. Comme précédemment, cette colle peut être une colle isolante si le microcircuit comporte des surépaisseurs sur ses zones de connexion, ou bien être une colle anisotrope si le microcircuit ne comporte pas de surépaisseurs sur ses zones de connexion.

L'opération suivante (figure 13) consiste à fixer le microcircuit 19 par la technique connue dite : "flip chip" en le déposant dans le réceptacle illustré à la figure 11b. Le microcircuit est positionné de façon que ses zones de connexion regroupées sur l'une de ses faces soient respectivement électriquement connectées aux plages de connexion 22 de l'ébauche. On peut utiliser l'une ou l'autre des deux colles mentionnées ci-dessus en fonction de la structure du microcircuit. D'autres modes de fixation peuvent aussi être utilisés notamment la soudure.

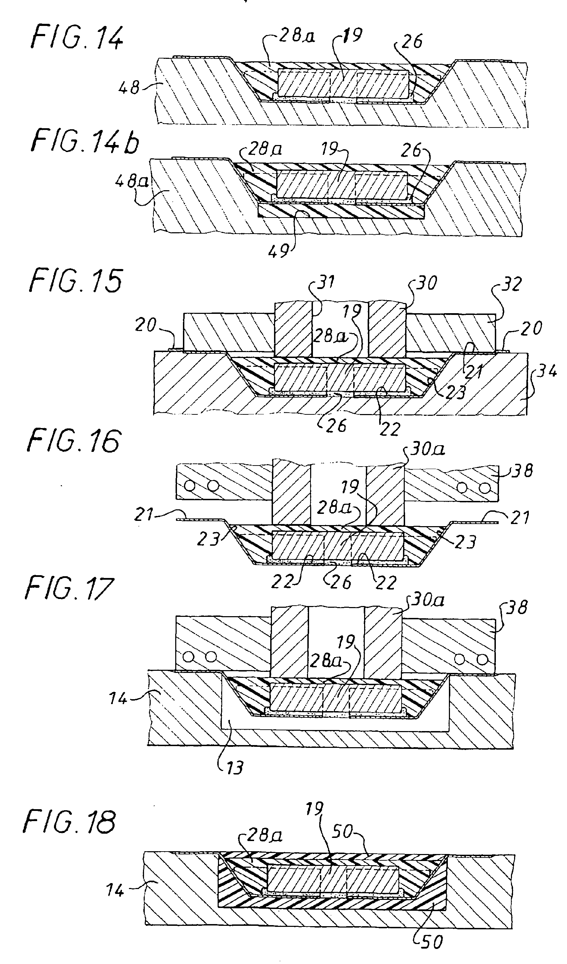

Ensuite, le microcircuit 19 peut être recouvert comme précédemment d'une goutte de résine. Dans l'exemple plus particulièrement représenté (figure 14), l'ébauche est placée dans un moule 48 pour recevoir la résine 28a. Le moule est de dimensions telles que les plages de raccordement extérieur 21 soient en dehors de celui-ci. Si le moule 48a comporte une partie 49 plus creuse que l'emplacement des plages de connexion 22 de l'ébauche (figure 14b), la résine pourra protéger et enrober les plages conductrices et la face active du microcircuit. A partir de ce moment, les marges 20 de l'ébauche ne sont plus nécessaires. On peut les éliminer par une opération représentée sur la figure 15. L'ébauche est prise en charge par un organe de préhension 30 comportant un orifice central relié à une source d'aspiration. Cet organe de préhension comporte aussi un outil de découpage 32 mobile axialement par rapport à l'organe de préhension. L'ébauche est placée dans une matrice de découpage 34 et l'outil est actionné pour éliminer les marges 20, ce qui a pour effet d'achever la constitution du réseau en individualisant les plages de raccordement extérieur 21. Le module est alors achevé. Il est repris par un organe de préhension 30a analogue fonctionnant par aspiration mais combiné à un outil de fixation chauffant 38, mobile axialement par rapport à l'organe de préhension. Par ce moyen, le module est placé dans la cavité 13 préparée à cet effet, de la carte 14 en matière plastique. C'est la situation illustrée à la figure 17. L'outil chauffant 38 est actionné pour fixer les plages de raccordement extérieur sur la face supérieure de la carte. L'outil vient plaquer à chaud lesdites plages de raccordement extérieur sur cette face et le module est, par ce moyen, fixé à la carte. Comme précédemment, l'adhérence des plages de raccordement extérieur sur la surface de la carte se fait par collage ou par pénétration de la matière thermoplastique constituant la carte dans des micropores ménagés à la surface du ruban conducteur.

La phase finale (figure 18) consiste à remplir la cavité avec une résine souple 50 polymérisant thermiquement ou par insolation aux rayons ultraviolets.

A titre de variante applicable aux deux modes de réalisation décrits ci-dessus, il est à noter qu'on peut réaliser simultanément les opérations précitées consistant à découper des parties extérieures de l'ébauche pour individualiser les plages de raccordement et à fixer celles-ci sur la carte. Pour ce faire, on place directement l'ébauche, comme obtenue à la figure 5 ou à la figure 14, dans la cavité 13 de la carte elle-même et on procède à une opération de pressage-découpage à chaud au moyen d'un seul outil chauffant dont les bords extérieurs sont adaptés pour découper les marges.

D'autres variantes peuvent être envisagées.

Par exemple, la conformation de l'ébauche peut être réalisée après la pose du microcircuit et le recouvrement de celui-ci par une goutte de résine.

Inversement, on peut procéder à la conformation de la feuille de matériau conducteur avant le prédécoupage définissant le réseau de conducteurs. Ce découpage partiel est suivi du montage du microcircuit par la technique dite : "flip chip". Ensuite, la protection du microcircuit peut être achevée en déposant dans l'ébauche une goutte de résine ou en procédant à une opération de surmoulage. La découpe finale, permettant d'éliminer les marges est ensuite mise en oeuvre et le module est mis en place et fixé dans la cavité selon l'un des enchaînements d'opérations décrits ci-dessus.

Une carte à microcircuit réalisée par mise en oeuvre d'un procédé conforme à l'invention est remarquable notamment en ce que la face active du microcircuit 19 comportant les zones de raccordement et les plages de raccordement 22 du réseau de conducteurs, auxquelles elle est connectée, ne sont pas directement fixées au fond de la cavité mais se trouvent légèrement à distance de ce fond et séparées de celui-ci, l'espace de séparation étant éventuellement rempli d'un matériau adapté, de préférence une résine isolante souple.

## Revendications

1. Procédé de fabrication d'une carte à microcircuit consistant notamment à aménager une cavité dans une partie de l'épaisseur d'une carte en matériau isolant formant support, ladite cavité ouvrant sur une face de cette carte, à créer un réseau de conducteurs pour établir des liaisons électriques entre la cavité et ladite face de la carte et à connecter ledit microcircuit à ce réseau de conducteurs, **caractérisé en ce qu'**il consiste à réaliser à part un module comprenant ledit réseau (17) et ledit microcircuit (19) de façon telle qu'une ébauche (16) dudit réseau soit conformée pour définir au moins en partie un réceptacle et que ledit microcircuit soit fixé à ce réseau en maintenant des parties différentes dudit réseau en position les unes par rapport aux autres, puis, successivement ou non, à découper des parties extérieures (20) de ladite ébauche matérialisant des plages de raccordement extérieur, à placer ledit module dans ladite cavité (13) avec lesdites plages de raccordement extérieur reposant sur ladite face et à fixer ces plages de raccordement extérieur sur ladite face.

2. Procédé selon la revendication 1, **caractérisé en ce qu'**une étape de réalisation de ladite ébauche consiste à découper les éléments dudit réseau dans une feuille de matériau conducteur (15) en incluant une marge extérieure les réunissant et à conformer (figure 3) ultérieurement ladite ébauche pour définir ledit réceptacle.

3. Procédé selon la revendication 1, **caractérisé en ce qu'**une étape de réalisation de ladite ébauche consiste à conformer une feuille de matériau conducteur définissant ledit réceptacle et à y découper ultérieurement, par exemple au moyen d'un faisceau laser, les éléments dudit réseau en laissant subsister une marge extérieure les réunissant.

4. Procédé selon la revendication 2 ou 3, **caractérisé en ce qu'**il consiste à assembler ledit microcircuit (19) à ladite ébauche (16) par une étape de montage connue en soi, dite "flip chip" établissant les liaisons électriques entre des zones de connexion dudit microcircuit définies sur une face de celui-ci et des plages de connexion de ladite ébauche.

5. Procédé selon la revendication 4, **caractérisé en ce que** le microcircuit comportant des surépaisseurs sur ses zones de connexion, il est collé (26) sur ladite ébauche au moyen d'une colle isolante de sorte que lesdites surépaisseurs soient en contact électrique avec lesdites plages de connexion.

6. Procédé selon la revendication 4, **caractérisé en ce que** le microcircuit est collé (26) au moyen d'une colle anisotrope sur ladite ébauche de sorte que ses zones de connexion soient en regard desdites plages de connexion.

7. Procédé selon l'une des revendications précédentes, **caractérisé par** une étape consistant, après fixation du microcircuit dans ledit réceptacle, à le recouvrir d'une résine durcissable (28) par polymérisation.

8. Procédé selon la revendication 7, **caractérisé en ce qu'**il consiste à découper les parties extérieures de ladite ébauche après recouvrement du microcircuit par ladite résine (figure 6).

9. Procédé selon la revendication 8, **caractérisé en ce qu'**il consiste à transporter le module ainsi obtenu après découpage desdites parties extérieures et à le placer dans ladite cavité de la carte (figure 7).

10. Procédé selon la revendication 7, **caractérisé en ce qu'**il comporte une opération consistant, après fixation du microcircuit, à déposer ladite ébauche dans un moule (48) de dimensions telles que lesdites plages de raccordement extérieur soient en dehors dudit moule et à enrober la partie située dans le moule par un matériau adapté.

11. Procédé selon la revendication 7, **caractérisé en ce qu'**il comporte une opération consistant à déposer ledit module dans un moule de dimensions telles que lesdites plages de raccordement extérieur soient en dehors de ce moule et à enrober la partie située dans ledit moule par un matériau adapté.

12. Procédé selon l'une des revendications précédentes, **caractérisé en ce qu'**il consiste à conformer ladite ébauche pour matérialiser ledit réceptacle, après montage dudit microcircuit.

13. Procédé selon l'une des revendications 1 à 11, **caractérisé en ce qu'**il consiste à conformer ladite ébauche (16) pour matérialiser ledit réceptacle avant montage dudit microcircuit.

14. Procédé selon la revendication 7, **caractérisé en ce qu'**il consiste à conformer ladite ébauche pour matérialiser ledit réceptacle après enrobage dudit microcircuit.

15. Procédé selon l'une des revendications précédentes, **caractérisé en ce que** ladite feuille de matériau conducteur dont sont issues lesdites plages de raccordement extérieur est recouverte, sur une face, d'une couche de colle activable à chaud et **en ce qu'**il consiste à plaquer à chaud (38) lesdites plages de raccordement extérieur sur ladite carte, après mise en place dudit module dans la cavité (figure 8).

16. Procédé selon l'une des revendications 1 à 14, **caractérisé en ce que** ladite feuille de matériau conducteur dont sont issues lesdites plages de raccordement extérieur est munie d'une face pourvue de micropores et **en ce qu'**il consiste à plaquer à chaud (38) lesdites plages de raccordement extérieur après mise en place dudit module dans la cavité.

17. Procédé selon l'une des revendications précédentes, **caractérisé en ce qu'**il consiste, après montage et fixation du module dans la cavité, à remplir celle-ci par un matériau de surenrobage adapté, par exemple une résine souple.

18. Procédé selon l'une des revendications 1 à 8, **caractérisé en ce qu'**on place ladite ébauche dans ladite cavité et **en ce qu'**on réalise simultanément les opérations précitées consistant à découper des parties extérieures de ladite ébauche et fixer lesdites plages de raccordement extérieur par une opération de pressage-découpage à chaud au moyen d'un seul outil chauffant.

19. Procédé selon l'une des revendications précédentes, **caractérisé en ce que** l'étape de conformation précitée consiste à créer un réceptacle sensiblement fermé sur cinq faces (figure 12b) par des parties de feuille dudit matériau conducteur, avant le montage dudit microcircuit et **en ce qu'**il consiste ultérieurement à déposer dans ce réceptacle un matériau de remplissage adapté, par exemple une résine durcissable.

## Claims

1. Process for manufacture of a microcircuit board consisting in particular of arranging a cavity in a part of the thickness of a board made of insulating material forming a support, the said cavity opening on one surface of this board, of creating a network of conductors to establish electrical connections between the cavity and the said surface of the board and of connecting the said microcircuit to this network of conductors, **characterised by** the fact that it consists of separately producing a module comprising the said network (17) and the said microcircuit (19) in such a manner that a blank (16) of the said network is shaped to at least partially define a container and that the said microcircuit is fixed to this network while keeping different parts of the said network in position relative to each other, and then, successively or otherwise, of cutting away outer parts (20) of the said blank to form external connection areas, of placing the said module in the said cavity (13) with the said external connection areas resting on the said surface and of fixing these external connection areas to the said surface.

2. Process as described in claim 1, **characterised by** the fact that a step in the manufacture of the said blank consists of cutting out the elements of the said network from a sheet of conductive material (15) including an outer border connecting them and subsequently shaping (figure 3) the said blank to define the said container.

3. Process as described in claim 1, **characterised by** the fact that a step in the manufacture of the said blank consists of shaping a sheet of conductive material defining the said container and of subsequently cutting out in it, for example by means of a laser beam, the elements of the said network, leaving remaining an outer border connecting them.

4. Process as described in claim 2 or 3, **characterised by** the fact that it consists of attaching the said microcircuit (19) to the said blank (16) by an installation step which is itself known, called □flip-chip□, establishing the electrical connections between connection zones of the said microcircuit defined on a surface of the latter and connection areas of the said blank.

5. Process as described in claim 4, **characterised by** the fact that the microcircuit including protrusions on its connection zones, it is adhered (26) to the said blank by means of an insulating adhesive so that the said protrusions are in electrical contact with the said connection areas.

6. Process as described in claim 4, **characterised by** the fact that the microcircuit is adhered (26) by means of an anisotropic adhesive to the said blank so that its connection zones are opposite the said connection areas.

7. Process as described in one of the preceding claims, **characterised by** a step consisting, after fixing of the microcircuit in the said container, of covering it with a polymerisation hardenable resin (28).

8. Process as described in claim 7, **characterised by** the fact that it consists of cutting off the outer parts of the said blank after covering the microcircuit with the said resin (figure 6).

9. Process as described in claim 8, **characterised by** the fact that it consists of conveying the module thus obtained after cutting off the said outer parts and placing it in the said cavity in the board (figure 7).

10. Process as described in claim 7, **characterised by** the fact that it includes an operation consisting, after fixing of the microcircuit, of depositing the said blank in a mould (48) of such dimensions that the said external connection areas are outside the said mould and of coating the part situated in the mould with a suitable material.

11. Process as described in claim 7, **characterised by** the fact that it includes an operation consisting of depositing the said module in a mould of such dimensions that the said external connection areas are outside this mould and of coating the part situated in the said mould with a suitable material.

12. Process as described in one of the preceding claims, **characterised by** the fact that it consists of shaping the said blank to produce the said container, after installation of the said microcircuit.

13. Process as described in one of claims 1 to 11, **characterised by** the fact that it consists of shaping the said blank (16) to produce the said container before installation of the said microcircuit.

14. Process as described in claim 7, **characterised by** the fact that it consists of shaping the said blank to produce the said container after coating of the said microcircuit.

15. Process as described in one of the preceding claims, **characterised by** the fact that the said sheet of conductive material from which the said external connection areas are produced is covered, on one surface, with a layer of heat-activatable adhesive and by the fact that it consists of hot-plating (38) the said external connection areas onto the said board, after the said module has been placed in position in the cavity (figure 8).

16. Process as described in one of claims 1 to 14, **characterised by** the fact that the said sheet of conductive material from which the said external connection areas are produced is provided with a surface provided with micro-pores and by the fact that it consists of hot-plating (38) the said external connection areas after the said module has been placed in position in the cavity.

17. Process as described in one of the preceding claims, **characterised by** the fact that it consists, after installation and fixing of the module in the cavity, of filling the latter with a suitable over-coating material, for example a flexible resin.

18. Process as described in one of claims 1 to 8, **characterised by** the fact that the said blank is placed in the said cavity and by the fact that the above-mentioned operations consisting of cutting off the outer parts of the said blank and fixing the said external connection areas are performed simultaneously by a hot cutting-pressing operation by means of a single heating tool.

19. Process as described in one of the preceding claims, **characterised by** the fact that the above-mentioned shaping step consists of creating a container substantially closed on five surfaces (figure 12b) by parts of sheet of the said conductive material, before installation of the said microcircuit and by the fact that it consists subsequently of depositing in this container a suitable filling material, for example a hardenable resin.

## Patentansprüche

1. Verfahren zur Herstellung einer Chipkarte, bestehend insbesondere darin, einen Hohlraum in einem Bereich der Dicke einer Karte aus Isoliermaterial auszubilden, welche einen Support bzw. eine Unterstützung ausbildet, wobei sich der Hohlraum auf eine Fläche bzw. Seite dieser Karte öffnet, ein Netz von Leitern bzw. Leiterbahnen auszubilden, um elektrische Verbindungen zwischen dem Hohlraum und der Fläche der Karte auszubilden und die Mikroschaltung mit diesem Netz von Leitern zu verbinden, **dadurch gekennzeichnet, daß** es darin besteht, einerseits ein Modul zu realisieren bzw. auszubilden, umfassend dieses Netz (17) und die Mikroschaltung (19), so daß eine Ausgangsform bzw. ein Rohling (16) des Netzes gebildet wird, um wenigstens teilweise eine Aufnahme zu definieren, und daß die Mikroschaltung an dem Netz festgelegt wird, indem unterschiedliche Teile des Netzes in Position relativ zueinander gehalten werden, danach aufeinander folgend oder nicht, äußere Teile (20) des Vorformlings bzw. Rohlings auszuschneiden, welche äußere Anschluß- bzw. Verbindungsbereiche darstellen, das Modul in den Hohlraum (13) anzuordnen, wobei die äußeren Verbindungsbereiche auf der Fläche aufliegen, und diese äußeren Verbindungsbereiche auf dieser Fläche festzulegen.

2. Verfahren nach Anspruch 1, **dadurch gekennzeichnet, daß** ein Schritt einer Ausführung des Rohlings aus einem Ausschneiden der Elemente des Netzes in einem Blatt aus leitfähigem bzw. leitendem Material (15), indem ein äußerer Rand inkludiert wird, welcher diese verbindet, und schließlich einem Ausbilden (Fig. 3) des Rohlings zum Definieren der Aufnahme besteht.

3. Verfahren nach Anspruch 1, **dadurch gekennzeichnet, daß** ein Schritt einer Ausführung des Rohlings aus einem Formen bzw. Ausbilden eines Blatts aus leitfähigem Material, welches die Aufnahme definiert, und schließlich einem Ausschneiden, beispielsweise mittels eines Laserschneidmittels bzw. -geräts der Elemente des Netzes besteht, indem ein dieser verbindender äußerer Rand bestehen gelassen wird.

4. Verfahren nach Anspruch 2 oder 3, **dadurch gekennzeichnet, daß** es aus einem Zusammenbauen der Mikroschaltung (19) mit dem Rohling (16) mittels eines an sich bekannten Montageschritts besteht, welcher "Flip Chip" genannt wird, welcher die elektrischen Verbindungen zwischen den Verbindungszonen der Mikroschaltung, welche auf einer Fläche derselben definiert werden, und den Verbindungsbereichen des Rohlings ausbildet.

5. Verfahren nach Anspruch 4, **dadurch gekennzeichnet, daß** die Mikroschaltung, welche Überdicken auf ihren Verbindungszonen umfaßt, auf den Rohling mittels eines Isolierklebers derart geklebt wird (26), daß die Überdicken in elektrischem Kontakt mit den Verbindungsbereichen sind.

6. Verfahren nach Anspruch 4, **dadurch gekennzeichnet, daß** die Mikroschaltung mittels eines anisotropen Klebers auf den Rohling derart geklebt wird (26), daß ihre Verbindungszonen den Verbindungsbereichen gegenüberliegen.

7. Verfahren nach einem der vorhergehenden Ansprüche, **gekennzeichnet durch** einen Schritt, der nach einer Festlegung der Mikroschaltung auf der Aufnahme darin besteht, sie mit einem **durch** Polymerisation härtbares Harz (28) abzudecken.

8. Verfahren nach Anspruch 7, **dadurch gekennzeichnet, daß** es aus einem Ausschneiden von äußeren Bereichen des Rohlings nach einer Abdeckung der Mikroschaltung mittels des Harzes besteht (Fig. 6).

9. Verfahren nach Anspruch 8, **dadurch gekennzeichnet, daß** es aus einem Transportieren des so erhaltenen Moduls nach einem Ausschneiden der äußeren Teile und einem Anordnen desselben in dem Hohlraum der Karte besteht (Fig. 7).

10. Verfahren nach Anspruch 7, **dadurch gekennzeichnet, daß** es einen Verfahrensschritt umfaßt, bestehend nach einer Festlegung der Mikroschaltung aus einem Anordnen bzw. Ablegen des Rohlings in einer Form (48) mit derartigen Abmessungen, daß die äußeren Verbindungsbereiche außerhalb der Form liegen, und einem Umhüllen des Bereichs, welcher in der Form angeordnet wird, mit einem adaptierten bzw. angepaßten Material.

11. Verfahren nach Anspruch 7, **dadurch gekennzeichnet, daß** es einen Verfahrensschritt umfaßt, bestehend aus einem Anordnen des Moduls in einer Form mit derartigen Abmessungen, daß die äußeren Verbindungsbereiche außerhalb dieser Form liegen, und einem Umhüllen des Bereichs, welcher in der Form angeordnet wird, mit einem adaptierten Material.

12. Verfahren nach einem der vorhergehenden Ansprüche, **dadurch gekennzeichnet, daß** es aus einem Ausbilden des Rohlings besteht, um die Aufnahme nach einer Montage der Mikroschaltung zu verwirklichen.

13. Verfahren nach einem der Ansprüche 1 bis 11, **dadurch gekennzeichnet, daß** es aus einem Ausbilden des Rohlings besteht, um die Aufnahme vor einer Montage der Mikroschaltung zu verwirklichen.

14. Verfahren nach Anspruch 7, **dadurch gekennzeichnet, daß** es aus einem Ausbilden des Rohlings besteht, um die Aufnahme nach einem Umhüllen der Mikroschaltung zu verwirklichen.

15. Verfahren nach einem der vorhergehenden Ansprüche, **dadurch gekennzeichnet, daß** das Blatt aus leitfähigem Material, von welchem die äußeren Verbindungsbereiche ausgehen, auf einer Fläche mit einer Schicht eines heiß aktivierbaren Klebers abgedeckt wird und daß es aus einem Heißplattieren (38) der äußeren Verbindungsbereiche auf der Karte nach einem Anordnen des Moduls in dem Hohlraum besteht (Fig. 8).

16. Verfahren nach einem der Ansprüche 1 bis 14, **dadurch gekennzeichnet, daß** das Blatt aus leitfähigem Material, von welchem die äußeren Verbindungsbereiche ausgehen, mit einer Seite bzw. Fläche versehen ist, die frei von Mikroporen ist, und daß es aus einem Heißplattieren (38) der äußeren Verbindungsbereiche nach einem Anordnen des Moduls in dem Hohlraum besteht.

17. Verfahren nach einem der vorhergehenden Ansprüche, **dadurch gekennzeichnet, daß** es nach einer Montage und Festlegung des Moduls in dem Hohlraum darin besteht, diesen mit einem adaptierten Verkleidungsmaterial, beispielsweise einem weichen Harz, zu füllen.

18. Verfahren nach einem der Ansprüche 1 bis 8, **dadurch gekennzeichnet, daß** der Rohling in dem Hohlraum angeordnet wird und daß gleichzeitig die zuvor genannten Verfahrensschritte ausgeführt werden, welche aus einem Ausschneiden der äußeren Teile des Rohlings und einem Fixieren der äußeren Verbindungsbereiche durch ein Preß/Heißschneidverfahren mittels eines einzigen Heizwerkzeugs bestehen.

19. Verfahren nach einem der vorhergehenden Ansprüche, **dadurch gekennzeichnet, daß** der vorgenannte Ausbildungs- bzw. Formschritt aus einem Erzeugen einer im wesentlichen auf fünf Flächen (Fig. 12b) geschlossenen Aufnahme durch Bereiche des Blatts aus leitfähigem Material vor der Montage der Mikroschaltung besteht, und daß es schließlich aus einem Abscheiden in der Aufnahme eines adaptierten Füllmaterials, beispielsweise eines härtbaren Harzes besteht.
